**Europäisches Patentamt**

(19) **European Patent Office**

**Office européen des brevets**

(11) Numéro de publication: **0 015 835**
**B1**

(12) **FASCICULE DE BREVET EUROPEEN**

(45) Date de publication du fascicule du brevet:
**01.02.84**

(21) Numéro de dépôt: **80400283.0**

(22) Date de dépôt: **29.02.80**

(51) Int. Cl.³: **H 01 L 29/36,** H 01 L 29/167,
H 01 L 29/743, H 01 L 29/08

(54) **Dispositif semiconducteur de commutation à fréquence élevée et procédé pour sa fabrication.**

(30) Priorité: **09.03.79 FR 7906132**

(43) Date de publication de la demande:
**17.09.80 Bulletin 80/19**

(45) Mention de la délivrance du brevet:
**01.02.84 Bulletin 84/5**

(84) Etats contractants désignés:
**DE GB IT**

(56) Documents cités:
**DE - A - 2 406 431**
**DE - A - 2 461 207**
**DE - A - 2 632 225**
**FR - A - 2 070 228**
**FR - A - 2 253 285**
**FR - A - 2 383 523**

(73) Titulaire: **THOMSON-CSF, 173, Boulevard Haussmann,**
**F-75379 Paris Cedex 08 (FR)**

㉜ Inventeur· **Collumeau, Yoland, "THOMSON-CSF" -**
**SCPI 173, Bld Haussmann, F-75360 Paris Cedex 08 (FP)**
Inventeur: **Lhorte, André, "THOMSON-CSF" -**
**SCPI 173, Bld Haussmann, F 75360 Paris Cedex 08 (FR)**

(74) Mandataire: **Favre, Maurice et al, "THOMSON-CSF" -**
**SCPI 173, bld Haussmann, F-75379 Paris Cedex 08 (FR)**

Dispositif semiconducteur de commutation à fréquence élevée et procédé pour sa fabrication

La présente invention se rapporte aux dispositifs semiconducteurs. Elle concerne principalement des dispositifs de commutation devant fonctionner à fréquence élevée, cette possibilité de fonctionnement à fréquence élevée résultant de la présence dans les couches centrales du dispositif semiconducteur, d'atomes d'un corps, tel que l'or ou le platine par exemple, constituant des centres de recombinaison de charges électriques.

Plus particulièrement la présente invention s'applique aux transistors de commutation et aux thyristors à conduction inverse. Un thyristor à conduction inverse comprend sur une même pastille de circuit intégré une structure de diode et une structure de thyristor en anti-parallèle, l'anode de la diode étant connectée à la cathode du thyristor et la cathode de la diode à l'anode du thyristor. Ces composants sont souvent utilisés pour des applications du domaine, par exemple, des onduleurs, des circuits à commutation forcée, des générateurs d'impulsions, et particulièrement dans les circuits de balayage pour les tubes cathodiques de télévision.

Cependant, une donnée de fonctionnement prend une importance fondamentale lorsque la fréquence des commutations est élevée, ce qui est par exemple le cas dans les circuits de balayage pour tubes cathodiques à image en télévision.

En effet, dans le cas d'un thyristor par exemple, celui-ci y est alors soumis à un régime cyclique, analysable en trois phases: il comporte d'abord l'application sur le thyristor non conducteur, d'une tension d'anode positive, ensuite la conduction du thyristor par application d'une tension d'amorçage sur son électrode de gâchette, et enfin le retour à l'état de non-conduction par cessation de l'application de la tension positive sur son anode.

Un nouveau cycle peut alors s'instituer, dont la première étape est à nouveau l'application d'une tension d'anode positive sur le thyristor non conducteur. Or cette application ne peut se faire que lorsque le thyristor est complètement libéré des porteurs de charges électriques résiduels créés pendant la phase de conduction précédente, dont la présence entraînerait le danger d'un amorçage prématuré, indépendant de toute action sur la gâchette. Il y a donc lieu de réduire, dans les applications où la vitesse de commutation est essentielle, la durée de vie de ces porteurs de charge qui conditionnent le temps de désamorçage, défini comme étant celui qui s'écoule entre l'extinction du thyristor et le moment où il peut à nouveau supporter, sans se ré-amorcer, une tension d'anode positive. En particulier, dans le cas d'un circuit de balayage de télévision, ce temps doit être très inférieur à la durée d'un cycle de balayage de ligne, durée typiquement de 65 µs pour 625 lignes.

Un autre intérêt s'attache à réduire ce temps, lié à la présence dans les circuits d'éléments réactifs (condensateurs et bobines d'auto-inductance), dont les dimensions diminuent avec l'énergie qu'ils ont à stocker, énergie proportionnelle au temps.

Des exigences analogues peuvent être étendues au cas des diodes et des transistors. Par exemple, dans le cas des diodes, il convient de réduire le temps qui s'écoule entre le moment où le courant direct qui traverse la diode s'annull et le moment ou la diode retrouve son pouvoir de blocage en tension inverse, temps habituellement désigné par le terme »temps de recouvrement inverse«; ce temps est, comme pour un thyristor, lié à la présence de porteurs de charges minoritaires créés pendant l'étape de conduction directe, dont la disparition demande un certain temps.

Un procédé connu utilisé pour réduire la durée de vie de ces porteurs consiste à disperser des atomes d'or dans les couches centrales de l'élément semiconducteur, comme l'enseigne par exemple le brevet français 1 232 232.

En pratique, la plaquette semiconductrice dans laquelle on crée le composant souhaité est soumise au dépôt d'une couche d'or, d'une épaisseur de l'ordre de 1000 Å, puis l'or est amené à diffuser vers l'intérieur de la pastille de silicium par un traitement thermique, pendant une durée de une à quelques heures, à une température comprise entre 800° et 900°C.

Cependant, il a été constaté que la migration des atomes d'or est freinée lorsqu'il est nécessaire de les faire traverser des régions de type de conductivité n fortement dopées (n+) qui agissent à la façon d'un masque, difficulté aisément surmontée en effectuant le dépôt d'or et sa diffusion à partir d'une face de la plaquette ne présentant pas l'interposition d'une telle région sur le passage des atomes d'or, c'est-à-dire à partir de l'anode dans le cas d'un thyristor.

Dans une réalisation particulière (brevet français 2 383 523), on a en outre proposé l'utilisation d'un phénomène de »getter« par lequel on modifie, au moyen d'un dopage local en tamis avec du bore ou du phosphore, la répartition de la concentration en atomes d'or (déjà introduits par une face ne présentant pas de forte concentration de type n+).

Mais une grave difficulté surgit dans le cas d'un transistor NPN ou d'un thyristor à conduction inverse. Dans ces deux cas, des régions de type de conductivité n fortement dopées sont présentes à la surface des deux faces principales de la plaquette, et compromettent ainsi la mise en place, à partir de l'une de celles-ci, dans des régions internes de la plaquette, des atomes d'or dont la fonction a été expliquée plus haut.

C'est le but de la présente invention que de proposer des dispositifs semi-conducteurs comprenant des couches n+ superficielles et ayant une structure permettant une diffusion d'atomes de corps

2

**0 015 835**

constituant des centres de recombinaison dans leurs couches internes.

Dans son fondement, l'invention fait appel à la mise en œuvre d'une pluralité de canaux, formés à travers le couche de type n$^+$ formant obstacle, entre la face externe et une couche intérieure du dispositif, canaux remplis de matériau semi-conducteur de même type que cette couche intérieure, et permettant l'acheminement des atomes des corps constituant des centres de recombinaison vers les couches internes du dispositif.

Plus précisément, l'invention se rapporte à un dispositif semiconducteur de commutation constitué d'une plaquette semiconductrice, comportant des couches alternées de type de conductivité p et n, des couches superficielles de type n à fort niveau de dopage affleurant dans des régions au moins de chacune des deux faces de la plaquette, l'une au moins de ces couches de type n à fort niveau de dopage étant superposée à une couche de même type n à plus faible niveau de dopage, les couches internes du dispositif renfermant des atomes de corps constituant des centres de recombinaison de charges électriques. Selon l'invention la couche de type n à fort niveau de dopage superposée à une couche de même type n à plus faible niveau de dopage comporte une pluralité de canaux constitués de prolongements de la couche de type n à plus faible niveau de dopage, le rapport de la surface totale de la pluralité de canaux avec la surface de la région à taux de dopage élevé étant compris entre 5 et 10%.

La présente invention vise également un procédé de fabrication d'une telle structure.

L'invention sera mieux comprise à l'aide de la description ci-après, en s'appuyant sur les figures annexées, ou:

— la figure 1 représente un dispositif semiconducteur connu du type thyristor avec diode intégrée;

— la figure 2 représente un dispositif semiconducteur selon l'invention, du type thyristor avec diode intégrée;

— la figure 3 représente, en axes cartésiens, la courbe caractéristique des variations de la chute de tension de la diode en direct, en fonction de la densité de courant;

— la figure 4 représente un autre mode de réalisation connu d'un thyristor avec diode intégrée;

— les figures 5a et 5b représentent deux modes de réalisation de transistors bipolaires de type »triple diffusé« en (a), et »épitaxié« en (b), selon l'invention.

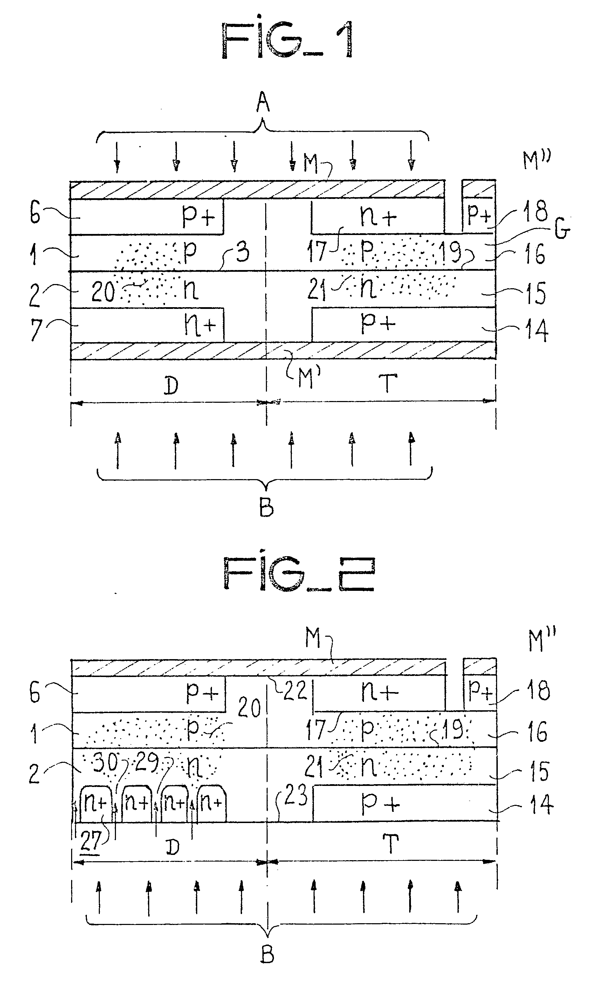

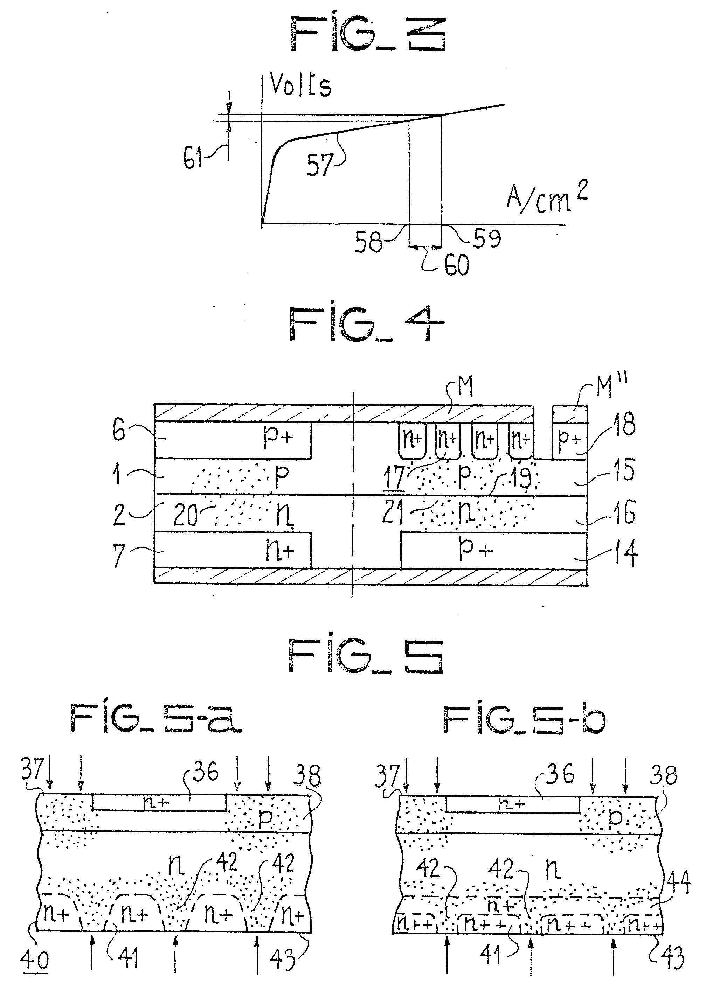

La figure 1 représente un dispositif du type thyristor à conduction inverse selon l'art connu, constitué de deux dispositifs semiconducteurs connectés en parallèle, d'une part un thyristor T à électrode de déclenchement G, électrode qui, dans toute la suite sera, par voie de simplification, désignée par le terme de gâchette, et d'autre part une diode D.

La diode D se compose d'une région d'anode 1 et d'une région de cathode 2, avec une surface commune 3 constituant la jonction redresseuse pn; les couches 6 et 7 de la diode respectivement marquées p$^+$ et n$^+$, à haute conductivité par dopage élevé appelées couches de contact ohmique permettent de constituer des contacts non redresseurs ou ohmiques avec les métallisations nécessaires au raccordement de la diode.

Le thyristor T se compose d'une couche d'anode 14 de type de conductivité p$^+$, d'une couche 15 de type n, d'une couche de gâchette 16 de type P, et d'une couche de cathode 17 de type n$^+$; la région 18 marquée p$^+$, à haute conductivité par dopage élevé, constitue la couche de contact ohmiques nécessaire au raccordement de la couche 16 de gâchette avec un circuit de commande extérieur non représenté.

Enfin, ainsi qu'on l'a indiqué, les connexions sont établies entre le thyristor et la diode par des couches métalliques telles que M et M'.

Les atomes d'or sont présents dans la zone centrale de la pastille semiconductrice à savoir les régions n et p 20 et 21, où ils sont représentés en pointillés.

Deux possibilités se présentent pour l'introduction des atomes d'or: la première consiste à effectuer la diffusion à partir de la face supérieure correspondant à la cathode du thyristor suivant les flèches A, la seconde consiste à l'effectuer à partir de la face suivants les flèches B.

Cependant, suivant le cas choisi, la concentration en atomes d'or ne sera pas la même dans les deux parties D et T, les régions de conductivité n à haut degré de dopage 17 et 7 s'opposant, ainsi qu'il a déjà été dit plus haut, à la pénétration de ces atomes. Les conséquences sur les caractéristiques électriques respectives du thyristor et de la diode, de temps de désamorçage $t_q$ d'une part, et de temps de recouvrement inverse $t_r$ d'autre part, sont directement liées au taux d'atomes d'or qui ont pu traverser et sont réunies dans le tableau ci-dessous, établi pour un cas typique de dispositif semiconducteur.

| Diffusion d'or | $t_q$ thyristor | $t_r$ diode | Conclusion |
|---|---|---|---|
| à partir de la face inférieure | 4,5 µs | 500 ns | thyristor dopé en atomes d'or // diode peu dopée |
| à partir des deux faces | 4,5 µs | 200 ns | thyristor et diode dopés |
| à partir de la face supérieure | 10–20 µs | 200 ns | thyristor non dopé en atomes d'or // diode dopée |

3

Ces valeurs expérimentales indiquent clairement que:

— dans le cas d'une diffusion d'or uniquement à partir de la face inférieure, la diode est relativement lente: il n'y a pas ou peu d'or dans les régions p, n 1 et 2 de la partie diode, indiquant un freinage par la région n+7;

— dans le cas d'une diffusion d'or uniquement à partir de la face supérieure, c'est le thyristor qui est relativement lent, il n'y a pas d'or dans les régions p n 15 et 16 de la partie thyristor, indiquant un freinage par la région n+17.

Pour réaliser un thyristor avec diode intégrée rapide, une solution consiste à faire diffuser l'or à partir des deux faces principales à la fois. Mais la multiplication des opérations de métallisation et de diffusion de la face supérieure nécessite des précautions particulières pour ne pas dégrader la jonction n+/p comprise entre les régions 16 et 17.

La figure 2 représente un dispositif semiconducteur du type thyristor avec diode intégrée selon l'invention, dont la structure est établie pour permettre la diffusion d'or, à partir de la face inférieure, vers les régions p, n centrales, sans rencontrer l'inconvénient du freinage de régions n+ indiqué plus haut.

Pour cela, l'invention prévoit un mode de réalisation particulier de la couche de contact ohmique de cathode 27, de type de conductivité n+, de la diode, qui est présente sur la face inférieure du dispositif, à savoir la création d'une pluralité de canaux tels que 29 et 30, à travers la région n+, conférant à cette région une structure en »tamis«.

Ces canaux sont remplis de matériau semiconducteur de type de conductivité n, dans lequel, après l'étape de métallisation, l'or peut aisément diffuser et atteindre les régions intermédiaires p et n 1 et 2 de la diode.

Quant aux régions intermédiaires 15 et 16 de la partie thyristor, elles sont atteintes par les atomes d'or 21 sans aucun freinage à travers la région d'anode p+14.

Les expériences effectuées par la demanderesse pour déterminer le rapport le meilleur entre la surface totale des canaux et la surface de la cathode n+27 ont montré que l'optimum est compris entre 5 et 10%, permettant le passage des atomes d'or sans affecter sensiblement la caractéristique de conduction directe de la diode.

Les résultats typiques, donnés à titre d'exemple dans les mêmes conditions que ceux du tableau (I) précédent, ont été un temps de désamorçage du thyristor de 4,5 $\mu$s, et un temps de recouvrement inverse de la diode de 220 ns, identiques aux résultats qu'on aurait obtenus en effectuant les diffusions d'atomes d'or à partir des deux faces, mais sans les inconvénients indiqués plus haut.

La figure 3 représente en axes cartésiens, la courbe caractéristique 57 des variations de la chute de tension de la diode en direct, en volts, en fonction de la densité de courant, en ampères par cm².

Pour un courant donné, la diminution de la surface de la couche de contact ohmique de cathode selon l'invention augmente la densité de courant de 58 à 59; mais la résistance dynamique, définie par le rapport de la variation de tension à la variation de la densité de courant est suffisamment faible pour que l'augmentation de la densité de courant 60 n'entraîne qu'un faible accroissement de la chute de tension en conduction directe 61.

La figure 4 représente un mode de réalisation classique de thyristor avec diode intégrée de l'invention dans lequel la zone de cathode 17 du thyristor est munie de canaux couramment appelés court-circuits d'émetteur. Cette structure est couramment utilisée pour modifier notablement certaines caractéristiques électriques du thyristor telles que résistance d'entrée entre gâchette et cathode, courant de commande par la gâchette, courant de maintien, caractéristiques de commutation en dV/dt et autres.

On pourrait dans ce cas envisager d'utiliser ces zones de court-circuits d'émetteur en tant que tamis selon la présente invention pour assurer la diffusion d'or à partir de la face supérieure. Toutefois, cela ne s'avère pas possible en pratique, la dimension des »trous« de court-circuit étant choisie pour optimiser les caractéristiques électriques évoquées ci-dessus et étant généralement trop faible pour permettre la diffusion d'or. Ainsi même dans le cas de la structure de la figure 4, on préférera, selon la présente invention, prévoir une couche de contact ohmique »en tamis« pour la cathode de la diode.

La figure 5 représente, suivant deux modes de réalisation, un transistor bipolaire NPN de type »triple diffusé« en (a), et épitaxié en (b), dotés d'une électrode selon l'invention.

En effet, bien qu'elle ait été décrite plus haut sur des exemples particuliers, l'invention n'est pas limitée aux thyristors à diode intégrée, et peut être généralisée à tout dispositif pour lequel il est nécessaire de réduire la durée de vie des porteurs minoritaires par l'introduction de centres de recombinaison, tels que des atomes d'or par exemple, afin d'améliorer les performances en régime de commutation, lorsque l'introduction de ces atomes doit avoir lieu à travers une couche de type n très fortement dopée. De plus, cette technique est exploitable chaque fois qu'une couche adjacente à la surface est très fortement dopée n, et du même type de conductivité que la couche sous-jacente, c'est-à-dire chaque fois qu'il existe une couche de type n+ ayant une fonction de couche de contact ohmique.

Dans le cas des transistors, la diffusion de centres recombinants constitue un moyen d'améliorer les performances à l'ouverture.

Dans le cas (a) pris comme exemple, cette diffusion, si elle est effectuée à partir de la face supérieure 37, ne passera pas à travers l'émetteur 36 de type n⁺. Elle passera à travers la base 38 de type p, mais alors la concentration en centres de recombinaison sera faible en vis à vis de l'émetteur, empêchant ainsi d'atteindre l'objectif. Il y a intérêt à ménager dans la couche de contact ohmique de collecteur 40, de type de conductivité n⁺, des canaux 42 de type n de la région intermédiaire, comme il est décrit dans le cas précédent de la figure 2. La diffusion de centres de recombinaison sera effectuée à partir de la face inférieure 43.

Il en sera de même avec le transistor épitaxié (b).

Dans ce cas, la région n⁺(44), qui est située dans un substrat obtenu par épitaxie, n'est pas suffisamment concentrée pour entraver gravement la diffusion des centres de recombinaison.

C'est alors dans la couche 41, qui est plus fortement dopée, que des canaux 42 sont aménagés.

Les dispositifs semiconducteurs selon l'invention ont été décrits dans le cas de thyristors avec diode intégrée, et de transistors bipolaires. Mais il doit être entendu que ces dispositifs ne l'ont été qu'à titre d'exemple.

De même, toute forme de la section droite des canaux caractéristiques de l'invention y est comprise, si elle satisfait à la condition du rapport des surfaces indiqué plus haut. C'est ainsi que la pluralité de canaux peut se présenter par exemple suivant des bandes parallèles à une direction particulière, ou à deux directions à angle droit réalisant un quadrillage.

Dans ce qui précède, il a été traité de »canaux« de type n ménagés dans des couches de contact ohmique de type n⁺. Cette image a été utilisée pour la clarté de la description. En fait, dans une structure semiconductrice, on formera d'abord la couche de type n et ensuite, par diffusion ou implantation d'un dopant de type n à forte concentration, la couche de contact ohmique. Cette diffusion ou implantation sera réalisée à travers un masque approprié en forme de tamis, de bandes ou de grille pour laisser affleurer en surface des zones de type N correspondant aux canaux selon l'invention.

Enfin, l'utilisation d'atomes d'or pour constituer des centres de recombinaison, assurant la réduction de la durée de vie de porteurs minoritaires, peut être remplacée par celle de tout autre élément pouvant assurer la même fonction, tel que le platine par exemple.

## Revendications

1. Dispositif semiconducteur de commutation a fréquence élevée constitué d'une plaquette semiconductrice, comportant des couches alternées de type de conductivité p et n, des couches superficielles de type n à fort niveau de dopage affleurant dans des régions au moins de chacune des deux faces de la plaquette, l'une au moins (7) de ces couches de type n à fort niveau de dopage étant superposée à une couche (2) de même type n à plus faible niveau de dopage, les couches internes du dispositif renfermant des atomes de corps constituant des centres de recombinaison de charges électriques, caractérisé en ce que ladite couche (7) de type n à fort niveau de dopage superposée à une couche (2) de même type n à plus faible niveau de dopage comporte une pluralité de canaux (29, 30) constitués de prolongements de la couche de type n à plus faible niveau de dopage, et en ce que le rapport de la surface totale de la pluralité de canaux avec la surface de la région à taux de dopage élevé est compris entre 5 et 10% de telle manière que les atomes de corps constituant les centres de recombinaison de charges électriques puissant alors, lors de leur introduction, diffuser sans freinage vers les dites couches internes du dispositif.

2. Dispositif semiconducteur selon la revendication 1, caractérisé en ce qu'il est du type transistor npn, la région à taux de dopage élevé étant constituée par le collecteur.

3. Dispositif semiconducteur selon la revendication 1, constitué d'un thyristor et d'une diode intégrés dans un substrat semiconducteur commun, l'anode de la diode étant connectée à la cathode du thyristor et la cathode de la diode étant connectée à l'anode du thyristor, caractérisé en ce que la région à taux de dopage élevé est constituée par la cathode de la diode.

4. Dispositif semiconducteur selon la revendication 1, caractérisé en ce que la pluralité de canaux est disposée suivant des lignes parallèles à une direction unique.

5. Dispositif semiconducteur selon la revendication 1, caractérisé en ce que la pluralité de canaux est disposée suivant des lignes parallèles à deux directions perpendiculaires entre elles, conférant à la région à taux de dopage élevé une structure en tamis.

6. Dispositif semiconducteur selon la revendication 1, caractérisé en ce que les corps constituant des centres de recombinaison de charges électriques comprennent l'or.

7. Dispositif semiconducteur selon la revendication 1, caractérisé en ce que les corps constituant des centres de recombinaison de charges électriques comprennent le platine.

8. Procédé de fabrication d'un dispositif semiconducteur de commutation comprenant des couches alternées de type de conductivité alterné et, sur l'une au moins de ses faces, une couche (7) de type n⁺ de niveau de dopage élevé, adjacente à une couche de type n moins dopée (20), les couches internes du dispositif renfermant des atomes de corps constituant des centres de recombinaison, caractérisé

**0 015 835**

en ce que des zones (27) de type n+ sont formées par diffusion ou implantation dans la couche de type n moins dopée à travers un masque ayant une configuration de tamis dont les mailles sont telles que, après diffusion, la surface effectivement occupée par la couche de type n+ occupe 90 à 95% de la surface totale correspondant au périmètre de cette couche, la surface restante étant alors occupée par une pluralité de canaux de type n; en ce que l'on dispose en suite une couche d'un corps constituant des centres de recombinaison de charges électriques sur la surface présentant lesdits canaux de type n et en ce que l'on fait diffuser dans le dispositif lesdits corps constituant les centres de recombinaison.

9. Procédé selon la revendication 8 caractérisé en ce que lesdits corps comprennent de l'or.

**Patentansprüche**

1. Halbleiter-Schaltvorrichtung für hohe Frequenzen, gebildet aus einer Halbleiterscheibe, die abwechselnde Schichten der Leitungstypen p und n umfaßt, wobei Oberflächenschichten vom n-Typ mit hohem Dotierungsniveau wenigstens mit Bereichen jeder der beiden Flächen der Scheibe bündig liegen, wobei wenigstens eine (7) dieser Schichten vom n-Typ mit hohem Dotierungsniveau einer Schicht (2) desselben n-Typs und mit niedrigerem Dotierungsniveau überlagert ist und wobei die Innenschichten der Vorrichtung Atome von Körpern umschließen, die Rekombinationszentren für elektrische Ladungen bilden, dadurch gekennzeichnet, daß die genannte Schicht (7) vom n-Typ mit hohem Dotierungsniveau, die einer Schicht (2) desselben n-Typs mit niedrigerem Dotierungsniveau überlagert ist, eine Mehrzahl von Kanälen (29, 30) umfaßt, die durch Verlängerungen der Schicht vom n-Typ mit niedrigerem Dotierungsniveau gebildet sind, und daß das Verhältnis der Gesamtoberfläche der Mehrzahl von Kanälen zur Oberfläche des Gebietes mit hohem Dotierungsniveau zwischen 5 und 10% beträgt, so daß die Atome der Körper, welche Rekombinationszentren für die elektrischen Ladungen bilden, bei ihrer Einleitung ungehemmt zu den Innenschichten der Vorrichtung hin diffundieren können.

2. Halbleitervorrichtung nach Anspruch 1, dadurch gekennzeichnet, daß sie vom Typ eines npn-Transistors ist, wobei das Gebiet mit hohem Dotierungsniveau durch den Kollektor gebildet ist.

3. Halbleitervorrichtung nach Anspruch 1, die aus einem Thyristor und einer Diode gebildet ist, welche in ein gemeinsames Halbleitersubstrat integriert sind, wobei die Anode der Diode mit der Kathode des Thyristors und die Kathode der Diode mit der Anode des Thyristors verbunden ist, dadurch gekennzeichnet, daß das Gebiet mit hohem Dotierungsniveau durch die Kathode der Diode gebildet ist.

4. Halbleitervorrichtung nach Anspruch 1, dadurch gekennzeichnet, daß die Mehrzahl von Kanälen entlang Linien angeordnet ist, welche parallel zu einer einzigen Richtung sind.

5. Halbleitervorrichtung nach Anspruch 1, dadurch gekennzeichnet, daß die Mehrzahl von Kanälen entlang Linien angeordnet ist, welche parallel zu zwei Richtungen sind, die aufeinander senkrecht sind, so daß dem Gebiet mit hohem Dotierungsniveau eine siebartige Struktur verliehen wird.

6. Halbleitervorrichtung nach Anspruch 1, dadurch gekennzeichnet, daß die Körper, welche Rekombinationszentren für elektrische Ladungen bilden, Gold enthalten.

7. Halbleitervorrichtung nach Anspruch 1, dadurch gekennzeichnet, daß die Körper, welche Rekombinationszentren für elektrische Leitungen bilden, Platin enthalten.

8. Verfahren zur Herstellung einer Halbleiterschaltvorrichtung mit abwechselnden Schichten abwechselnden Leitungstyps und einer auf wenigstens einer ihrer Flächen angeordneten Schicht (7) vom Typ n+ mit hohem Dotierungsniveau, welche an eine Schicht vom Typ n mit niedrigerem Dotierungsniveau (20) angrenzt, wobei die Innenschichten der Vorrichtung Atome von Körpern enthalten, die Rekombinationszentren bilden, dadurch gekennzeichnet, daß Zonen (27) vom Typ n+ durch Diffusion oder Implantation in der Schicht vom n-Typ und mit niedrigerem Dotierungsniveau über eine Maske gebildet sind, welche eine siebartige Gestalt aufweist, wobei die Maschen des Siebes derart sind, daß nach der Diffusion die von der Schicht des Typs n+ effektiv eingenommene Oberfläche 90 bis 95% der Gesamtoberfläche entsprechend dem Umfang dieser Schicht ausmacht, wobei die verbleibende Oberfläche von einer Mehrzahl von Kanälen des Typs n eingenommen wird; daß anschließend eine Schicht von Körpern, welche Rekombinationszentren für elektrische Ladungen bilden, auf der die Kanäle vom n-Typ aufweisenden Oberfläche angeordnet wird; und daß die die Rekombinationszentren bildenden Körper in die Vorrichtung eindiffundiert werden.

9. Verfahren nach Anspruch 8, dadurch gekennzeichnet, daß die genannten Körper Gold enthalten.

**Claims**

1. High-frequency semiconductor switching device constituted by a semiconductor wafer comprising alternating layers of conductivity type p and n, surface layers of type n of high doping level being flush at least with regions of each of the two faces of the wafer, at least one (7) of said layers of n type and of high doping level being superposed on a layer (2) of the same n type and of weaker doping level, the inner layers of the device enclosing atoms of bodies constituting recombination centres for electrical charges, characterized in that said layer (7) of type n of high doping level superposed on a layer (2) of the same type n of weaker doping level comprises a plurality of channels (29, 30) formed by extensions of the layer of type n with weaker doping level, and in that the ratio of the total surface of the plurality of channels to the surface of the region of high doping level lies between 5 and 10% in such a manner that the atoms of bodies forming the recombination centres for the electrical charges on their introduction can diffuse without obstruction towards said inner layers of the device.

2. Semiconductor device according to claim 1, characterized in that it is of the npn transistor type, the region of high doping level being constituted by the collector.

3. Semiconductor device according to claim 1, formed by a thyristor and a diode integrated in a common semiconductor substrate, the anode of the diode being connected to the cathode of the thyristor and the cathode of the diode being connected to the anode of the thyristor, characterized in that the region of high doping level is formed by the cathode of the diode.

4. Semiconductor device according to claim 1, characterized in that the plurality of channels is disposed along lines parallel to a single direction.

5. Semiconductor device according to claim 1, characterized in that the plurality of channels is disposed along lines parallel to two direchtions perpendicular to each other, imparting to the region of high doping level a sieve-like structure.

6. Semiconductor device according to claim 1, characterized in that the bodies constituting the recombindation centres for electrical charges contain gold.

7. Semiconductor device according to claim 1, characterized in that the bodies constituting the recombination centres for electrical charges contain platinum.

8. Method of fabricating a semiconductor switching device comprising alternating layers of alternating conductivity type and, on at least one of its faces, a layer (7) of type $n^+$ of high doping level, adjacent a layer of type n of lower doping level (20), the inner layers of the device containing atoms of bodies forming recombination centres, characterized in that zones (27) of type $n^+$ are formed by diffusion or implantation in the layer of type n of lower doping level through a mask having a sieve-like configuration of which the meshes are such that after diffusion the surface effectively occupied by the layer of type $n^+$ occupies 90 to 95% of the total surface corresponding to the perimeter of said layer, the remaining surface being occupied by a plurality of channels of type n, that a layer of a body forming the recombination centres for electrical charges is then disposed on the surface having the channels of type n, and that said bodies forming the recombination centres are diffused into the device.

9. Method according to claim 8, characterized in that said bodies contain gold.

0 015 835

## FIG_1

## FIG_2

# FIG_3

Volts

57

61

A/cm²

58   59

60

# FIG_4

M          M''

6        p+            n+ n+ n+ n+    p+      18

1              p              17    p    19        15

2      20        n          21        n            16

7            n+                    p+              14

# FIG_5

## FIG_5-a

37          36          38

n+              p

n      42   42

n+   n+    n+   n+

40      41        43

## FIG_5-b

37          36          38

n+              p

42    42    n              44

n+

n++  n++    n++  n++

41        43